# EUROPEAN PATENT APPLICATION

(11) **EP 4 297 067 A1**
(43) Date of publication of application: **27.12.2023**
(21) Application number: 22180182.2
(22) Date of filing: 21.06.2022
(51) Int. Cl.: H01L 21/02, H01L 29/775, H01L 29/78, H01L 29/786, H01L 21/336

(54) **MANUFACTURING METHOD FOR A POWER SEMICONDUCTOR DEVICE AND POWER SEMICONDUCTOR DEVICE**

(71) Applicant: Hitachi Energy Ltd, 8050 Zürich (CH)
(72) Inventor: WIRTHS, Stephan, 8800 Thalwil (CH); KNOLL, Lars, 5607 Hägglingen (CH)
(74) Representative: Epping - Hermann - Fischer

(57) **Abstract**

The present disclosure relates to a manufacturing method for a power semiconductor device (20), comprising: forming at least one insulating layer (3) on a surface (2a) of a crystalline growth substrate (2), the at least one insulating layer (3) comprising at least one cavity (4) extending in a lateral direction (22) within the at least one insulating layer (3); selectively growing a wide bandgap, WBG, semiconductor material within the cavity (4) to form a lateral epi-layer (9), wherein a surface area of the growth substrate (2) exposed through at least one passage (5) formed between the at least one cavity (4) and the growth substrate (2) is uses as a seed area for epitaxially growing the WBG semiconductor material; and forming at least one semiconductor junction, in particular a pn junction (6), a np junction or a Schottky junction (8), within or at an end of the selectively grown WBG semiconductor material.

The disclosure further relates to a power semiconductor device (20) in general, and a MISFET (25) in particular.

## Description

The present disclosure relates to a manufacturing method for a power semiconductor device and a corresponding power semiconductor device with an epi-layer comprising a wide bandgap semiconductor material.

Wide bandgap (WBG) semiconductor materials, such as silicon carbide (SiC), have advantageous properties, including a high critical electric field and electron mobility or high frequency switching. Accordingly, they yield a much larger Baliga figure-of-merit (BFOM) compared to commonly used semiconductor materials, such as silicon, making them a good option for power semiconductor device, such as power MISFETS. These advantages are enabling several applications for energy efficiency and electric transportation. However, the relatively high cost and processing complexity involved in manufacturing power semiconductor device comprising epitaxially grown layers (epi-layer) of WBG materials limits their application in many fields.

Embodiments of the disclosure relate to a manufacturing method for a power semiconductor device and a corresponding power semiconductor device comprising a selectively grown, lateral epi-layer, which can be manufactured using less wide bandgap semiconductor material and/or in a shorter time.

According to a first aspect, a manufacturing method for a power semiconductor device is disclosed. The manufacturing method comprises:
- forming at least one insulating layer on a surface of a crystalline growth substrate, the at least one insulating layer comprising at least one cavity extending in a lateral direction within the at least one insulating layer;
- selectively growing a wide bandgap, WBG, semiconductor material within the cavity to form a lateral epi-layer, wherein a surface area of the growth substrate exposed through at least one passage formed between the at least one cavity and the growth substrate is uses as a seed area for epitaxially growing the WBG material; and
- forming at least one semiconductor junction, in particular a pn junction, a np junction or a Schottky junction, within or at an end of the selectively grown WBG semiconductor material.

Among others, the inventors have found that the amount of WBG material required for manufacturing of a power semiconductor device can be reduced if the WBG material used, for example, in an active area of the device is selectively grown rather than etched from a bulk epi-layer of WBG material. In other words, an additive rather than a subtractive manufacturing approach is used. The growth of the WBG material can be controlled in a desired direction, for example a lateral direction, by at least one insulating layer comprising a cavity acting as a growth template. This also allows to grow the WBG material, such as 3C, 4H or 6H silicon carbide (SiC), on a substrate made from a different material, such as doped or undoped silicon (Si), SiC-on-Si, SiC-on-Insulator (SiCOI), sapphire or gallium nitride (GaN), further reducing the amount of WBG material required.

In at least one implementation, the at least one passage is configured as a defect filter for the WBG material, such that the lateral epi-layer is essentially defect-free. The smoother surface of selectively grown, essentially defect free WBG structure, improves a carrier mobility within the grown epi-layer compared to a dry-etched epi-layer.

In at least one implementation, the at least one semiconductor junction is formed by incorporating at least one dopant during the selective growth of the WBG semiconductor material, in particular during the growth of the lateral epi-layer. In this way, growth and doping of the active region can be performed in a single processing step, further simplifying the manufacturing process and allowing well defined differences in carrier concentrations in respective regions of the epi-layer, corresponding, for example, to a step or box with respect to a concentration of the at least one dopant. Even more, it will substantially reduce the cost of manufacturing by avoiding ion implantation and/or high temperature dopants activation processes required for some existing WBG semiconductor manufacturing methods.

In at least one implementation, the step of forming at least one insulating layer comprises: forming a first dielectric layer, in particular a first silicon dioxide layer, on a surface of the growth substrate; forming at least one hole in the first dielectric layer to form the at least one passage; depositing and structuring a sacrificial material in an area corresponding to the at least one cavity; forming a second dielectric layer, in particular a second silicon dioxide layer, on the first dielectric layer and the sacrificial material; and removing the sacrificial material so as to form the at least one cavity between the first dielectric layer and the second dielectric layer. In this way, the cavity forming the growth template can be formed using well-established semiconductor processing steps and environments, such as CMOS industry reactors used for processing conventional, non-WBG semiconductor wafers, for example 200 mm silicon wafers.

According to a second aspect, a power semiconductor device is disclosed. The device comprises:
- a substrate comprising a first material;
- at least one insulating layer arranged on a surface of the substrate and comprising at least one cavity, the at least one cavity extending in a lateral direction within the at least one insulating layer;
- at least one passage formed between the at least one cavity and the substrate;
- at least one epi-layer comprising a second material, a first part of the at least one epi-layer extending in the lateral direction in the at least one cavity and at least a second part of the at least one epi-layer extending in a vertical direction through the opening to contact the first material, wherein the second material is a wide bandgap, WBG, semiconductor material different from the first material; and
- at least one semiconductor junction, in particular a pn junction, a np junction or a Schottky junction, formed within or at an end of the at least one epi-layer.

Such a device combines the advantageous electrical properties of an epi-layer comprising a WGB semiconductor material, with the simple connectivity of lateral power semiconductor devices, as well as a use of a substrate formed from a different, potentially cheaper bulk material.

The disclosed structure offers significant improvements in device capability compared with existing power semiconductor devices. Among others, it allows to circumvent a mobility degradation, a major issue in conventional SiC MOSFETs. The high density of interface states in SiC MOS structures limits the potential of WBG materials. In contrast, the potentially very high surface-to-volume ratio of the proposed lateral epi-layer increases, for example, a channel density of a MOSFET and reduces off-currents, thus offering a lower static power consumption.

In at least one implementation, the first material comprises at least one of doped silicon (Si), undoped Si, 4H, 6H or 3C silicon carbide (SiC), for example 3C-on-Si, SiC-on Insulator (SiCOI), semi-insulating SiC, sapphire or gallium nitride (GaN). Alternatively or in addition, the second material comprises at least one of 3C, 4H or 6H silicon carbide. Alternatively or in addition, the at least one insulating layer comprises silicon dioxide. The above materials are suitable for established semiconductor manufacturing processes, and comprises a number of advantageous properties, such as low cost or good insulation properties, compared to a device comprising only a single WBG material. Accordingly, those materials allow an economical fabrication of power semiconductor devices with an epi-layer comprising a WBG semiconductor material.

In at least one implementation, the first part of the at least one epi-layer extends in the lateral direction for 5 to 10 µm and/or the a first part of the at least one epi-layer extends in a vertical direction for 0.1 to 0.5 µm. Alternatively or in addition, the a first part of the at least one epi-layer extends in the lateral direction for a first length, the first length exceeding a depth of the cavity in the lateral direction by a factor of 10 or more, leading to a very high surface-to-volume ratio of the proposed lateral epi-layer.

Alternatively or in addition, the power semiconductor device comprises multiple lateral parts of the at least one epi-layer and/or multiple passage formed between the at least one cavity and the substrate, wherein a pitch distance of the multiple lateral parts and/or multiple passage, respectively, lies in the range of 50 to 5000 nm, such as 50 to 500 nm. For example, an active area of each cell of a multi-cell semiconductor device may comprises a dense array of grown platelets with diameters and pitches of only several tens to hundreds of nanometers.

In at least one implementation, the power semiconductor device comprises a lateral drift structure, wherein the lateral drift structure comprises at least a first section of the first part of the at least one epi-layer, the first section comprising a first dopant to form a semiconductor material of a first type, in particular an n type WBG semiconductor material. Lateral drift layers with only several µm can be sufficient to block voltage up to 1kV, when grown on a suitable substrate, such as a High Purity Semi-Insulating (HPSI) substrate.

In at least one implementation, the power semiconductor device comprises a lateral and/or vertical npn structure, the lateral and/or vertical npn structure comprising the at least one semiconductor junction formed within the at least one epi-layer. Moreover, the cavity allows to form both lateral and/or vertical npn structures, as required for the intended power semiconductor device.

In at least one implementation, the power semiconductor device comprises at least two lateral drift structures and/or lateral npn or pnp structures, wherein the at least two lateral drift structures and/or lateral npn or pnp structures are connected in at least one of a back-to-back or serial fashion. This enables to distribute high currents or high voltages over multiple active structures, by electrically connecting individual structures, such as switching cells of a multi-cell switching device, in parallel or series, respectively.

In at least one implementation, the power semiconductor device comprises a metal insulator semiconductor field effect transistor (MISFET), in particular one of a lateral super-junction MISFET, an IGBT or an AccuFET. The MISFET comprises at least one of the following: at least one gate electrode partially or completely enclosing the at least one epi-layer, in particular a central part of a lateral or vertical npn or npn structure formed therein; at least one source region arranged at a first lateral end and/or in a central section of the epi-layer; and at least one drain region arranged in a central section and/or at a second lateral end of the epi-layer. Among others, the described design enables a superior gate control using a gate at least partially wrapped around the selectively grown epi-layer. The coupling of such a wrapping gate leads to thicker inversion charge layers, which can improve the inversion channel carrier mobility by reduced coulomb scattering, for example, at gate dielectric/SiC interface traps. This is turn leads to an additional boost in drain current density. It also allows to eliminate conventionally used p+ plugs used, for example, in state-of-the-art SiC MOSFETs to ground a well region.

In at least one alternative implementation, the power semiconductor device comprises a lateral power diode.

In at least one implementation, the power semiconductor device has a voltage class or rating of 0.6 to 1.2 kV per device. Such devices can be used, for example, in inverters and other power control circuits of electric vehicles (EVs).

The manufacturing method according to the first aspect above is particularly suitable for manufacturing the power semiconductor device according to the second aspect. Features and advantages described in connection with the method can therefore be used in the device and vice versa. Thus, every feature described with respect to one of the aspects is also disclosed herein with respect to the other aspect, even if the respective feature is not explicitly mentioned in the context of the specific aspect.

The accompanying figures are included to provide a further understanding. In the figures, elements of the same structure and/or functionality may be referenced by the same reference signs, even if they are not identical in all respects. It is to be understood that the embodiments shown in the figures are illustrative representations and are not necessarily drawn to scale.
Figure 1 is a schematic cross-section through a semiconductor device having a selectively grown WBG epi-layer.
Figures 2 to 8 show perspective views of processing steps of a method for manufacturing a power semiconductor device.
Figure 9 shows a perspective view of a finished power semiconductor device comprising multiple cells.
Figure 10 shows a schematic cross-section through a semiconductor device having a lateral and/or vertical channel region formed in a selectively grown epi-layer.
Figure 11 shows another perspective view of a power semiconductor device with multiple cells.

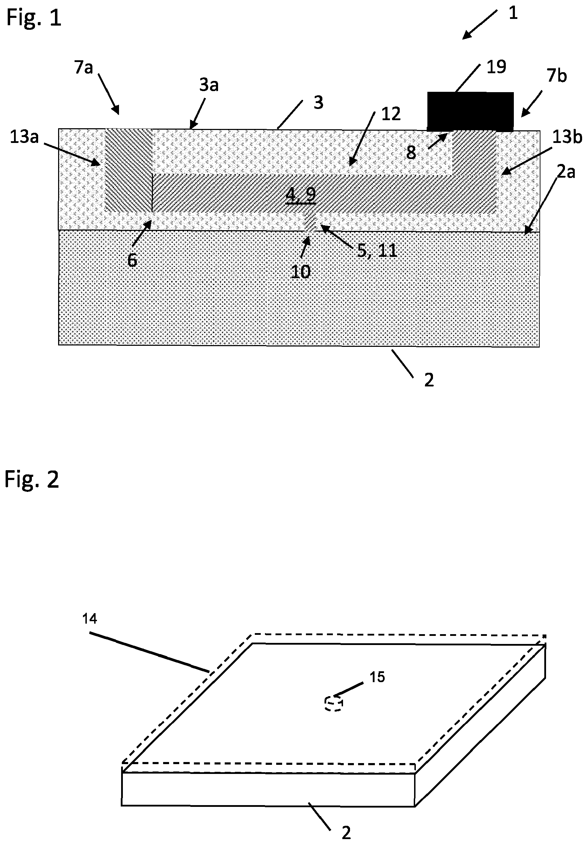

Before specific power semiconductor devices and processing steps are described in detail, firstly selective growth of a lateral epitaxial layer (epi-layer) is described with reference to Figure 1.

Figure 1 shows a semiconductor structure 1 comprising a substrate 2, and an insulating layer 3 formed on a main surface 2a, in case of Figure 1 its top surface, of the substrate 2. Within the insulating layer 3, a cavity 4 is formed. The cavity 4 is connected by means of a passage 5 with the surface 2a of the substrate 2. The cavity 4 further extends to two openings 7a and 7b to a top surface 3a of the insulating layer 3.

Suitable WBG materials, such as 3C SiC can be grown at low temperatures on a suitable substrate 2, such as a Si substrate to form an epitaxially grown layer 9. The crystalline material of the substrate 2 serves as a seed material for forming the selectively grown epi-layer 9 within the cavity 4. For example, chemical vapour deposition (CVD) may be employed to introduce a growth material through the openings 7a and/or 7b. During epitaxy, the insulating layer 2 with the cavity 4 formed therein acts as a hollow growth mask for the WBG material, and allows to selectively grow the epi-layer 9 to shapes and dimensions suitable for forming power semiconductor devices.

Growth starts from a seed area 10 at the bottom of the passage 5 and then first extends in a vertical direction, to form a first vertical part 11 of the epi-layer 9. Once the growth front reaches the larger, lateral part of the cavity 4, growth extends laterally in both directions to form a lateral part 12 of the epi-layer 9. Once the growth material reaches the respective lateral ends of the cavity 4, growth once more extends in the vertical direction to form respective second vertical parts 13a and 13b of the epi-layer 9 that extend towards the openings 7a and 7b, respectively.

Preferably, the seed area 10 of the surface 2a exposed through the passage 5 is kept relatively small. For example, it may have a diameter of 10 to 500 nm. If the seed area 10 is so small that the wide bandgap material growth starts only from a single growth seed, defects due to lattice mismatches between the grown WBG material of the epi-layer 9 and the material of the substrate 2 can be avoided. Even if some defects are present, for example due to a larger opening of the passage 5, such defects can be filtered out in the first vertical part 11, before the WBG material reaches the larger, lateral part 12 of the epi-layer 9, which is used to form an active part of the finished semiconductor device as described later. Accordingly, the passage 5 effectively functions as a defect filter, resulting in a virtually defect-free lateral part 12 and second vertical parts 13a and 13b of the epi-layer 9.

In the described example, the substrate 2 may be a wafer formed from doped or undoped silicon, for example Si(001), Si(011) or Si(111). The substrate 2 may also be formed from another crystalline material, such as a hexagonal crystal, such as hexagonal SiC, such as 4H or 6H SiC. Alternatively, the substrate may also be formed of or comprise other crystalline materials, such as gallium nitride (GaN), Ga₂O₃, semi-insulating (S) materials, such as SiC (on-axis), or Si-or C-face SiC substrates. GaN, 3C SiC, 4H SiC, Ga₂O₃ or diamond may be used as a suitable wide bandgap material of the selectively grown epi-layer 9.

Figure 1 further shows that two semiconductor junctions are formed within or at an end of the selectively grown epi-layer 9. In particular, a pn or np junction 6 is formed within the lateral part 12, close to the second vertical part 13a. Moreover, a Schottky junction 8 is formed between the upper end of the second vertical part 13b and a metal material of an electrode 19 formed above it. To form such junctions, any dopants, and consequently any desired doping level, can be incorporated along the growth direction during the selective growth of the epi-layer as detailed later.

Figures 2 to 8 show how a corresponding semiconductor structure 1 can be formed in more detail.

Figure 2 shows a first stage of a manufacturing procedure, wherein a first dielectric layer 14 has been formed on a top surface 2a of a substrate 2. For example, a SiO₂, Si₃N₄, Al₂O₃ or similar dielectric layer may be formed on a silicon or SiC substrate. At this stage, a hole 15 is formed in the first dielectric layer 14, which will later form the passage 5. The hole 15 may be formed, for example, by dry etching.

Although not shown in Figure 2, more than one hole 15 may be formed with a given pitch. Multiple holes can be used to form multiple seed areas 10 for one or more cells of a semiconductor device at the same time, as described later.

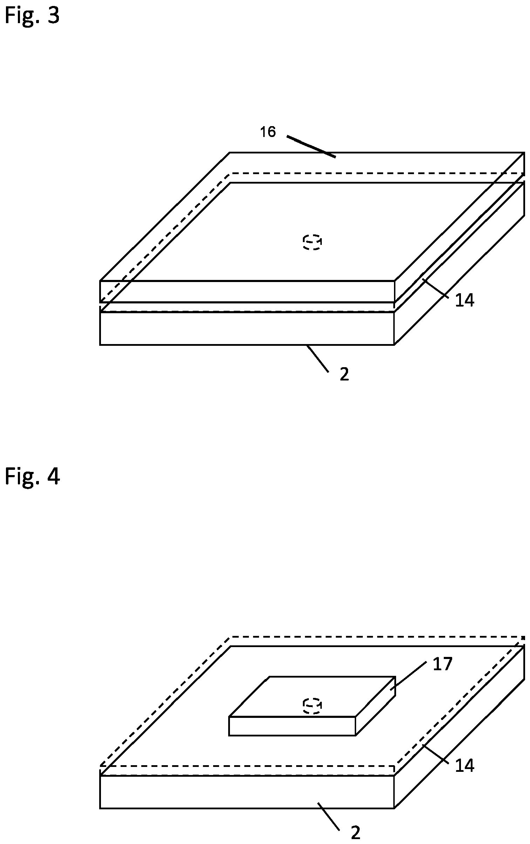

Figure 3 shows the deposition of a sacrificial layer 16 on the previously formed dielectric layer 14. The sacrificial layer 16 may comprise amorphous silicon (a-Si), carbon or another suitable material.

Figure 4 shows the formation of a growth template 17. As shown in Figure 4, the growth template 17 is formed by dry etching parts of the previously formed sacrificial layer 16. The growth template 17 corresponds to the lateral part 12 of the epi-layer 9 to be formed later by selective growing. As shown, the growth template 17 may take the form of a plate or platelet, in particular a nano-platelet. Alternatively, the growth template 17 may also take the form of one or more interconnected bars, fins or wires, in particular a tree-shaped network of nanowire (not shown).

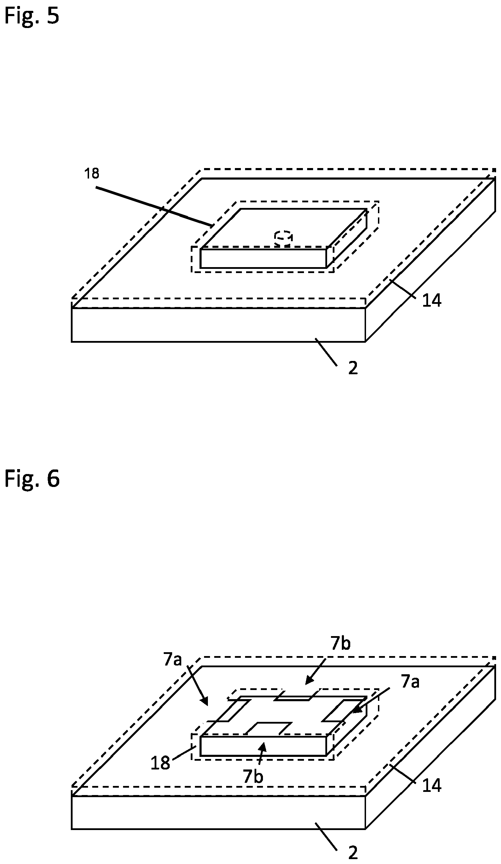

Figure 5 shows the formation of a second dielectric layer 18 or cover in the area of the growth template 17. Effectively, the second dielectric layer 18 covers the remaining sacrificial material of the growth template 17 on the top and side surfaces to fully embed the growth template 17 between the first dielectric layer 14 and the second dielectric layer 18. Like the first dielectric layer 14, the second dielectric layer 18 may be formed of SiO₂, Si₃N₄, Al₂O₃ or other suitable insulating materials.

Figure 6 shows the formation of various openings in the second dielectric layer 18. Such openings may be formed using dry etching. The openings may correspond with terminal regions of the finished power semiconductor device, or may be auxiliary openings allowing the introduction of a growth material into the later formed cavity. In the described example, two opposite first openings 7a correspond to source regions of a double MOSFET structure, whereas two second openings 7b correspond to respective drain openings. The second openings 7b are arranged in a central part of the growth template 17 in the middle of the two opposite first openings 7a.

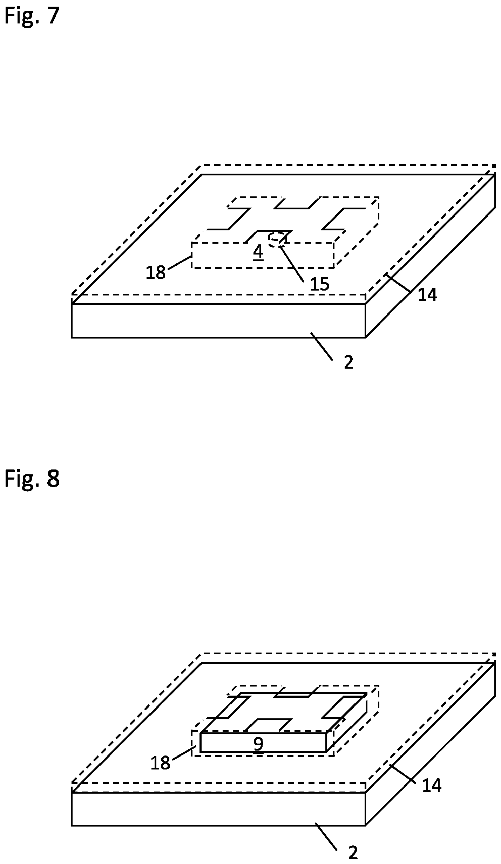

Figure 7 shows the removal of the sacrificial material of the growth template 17. At this stage, the cavity 4 is formed within the insulating material of the first dielectric layer 14 and the second dielectric layer 18. This can be achieved, for example, by etching the sacrificial material using TMAH, KOH, XeF2, or a similar etching agent, which can be introduced through the openings 7a and 7b.

In the step shown in Figure 8, the cavity 4 is filled with a suitable WBG material, to form an epi-layer 9 therein. This is achieved by selectively growing the WBG material starting from the hole 15 (no longer visible in Fig. 8) and then continuing throughout the cavity 4 until the growth front reaches the respective openings 7a and 7b. This growth can be achieved, for example, using conventional semiconductor processing methods such as CVD.

During the growth, dopants can be introduced into the evaporated WBG material to form regions with increased or reduced charge carrier concentration as desired. Because the growth front of the WBG material proceeds along a channel defined by the cavity 4, steps or box functions in the dopant profile are well defined, as described later with respect to specific power semiconductor devices.

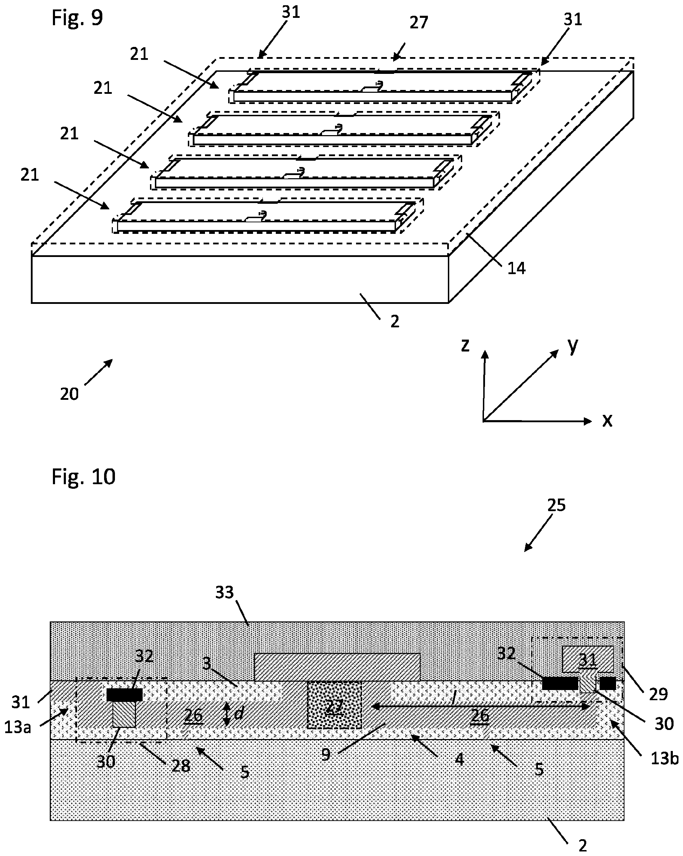

Figure 9 shows a power semiconductor device 20 comprising a plurality of cells 21. Specifically, the power semiconductor device 20 shown in Figure 9 comprises a total of four device cells 21 arranged in parallel on a top surface 2a of the substrate 2. Each one of the device cells 21 comprises a semiconductor structure 1 similar to the one described above with regard to Figures 2 to 8. As each of the device cells 21 has essentially the same structure, these can be processed and grown in parallel using conventional semiconductor processing methods, potentially using different material.

Figure 9 further shows that each one of the semiconductor structures primarily extends in a first lateral direction corresponding to the x-axis, over a considerably larger length than in an orthogonal, second lateral direction corresponding to the x-axis, or a vertical direction 24 corresponding to the z-axis.

As described later, each of the cells 21 implements a double MISFET structure, connected back-to-back in a drain region 27. If the respective opposite source region 31 are electrically connected in parallel, a voltage drop is spread over half the length of the lateral structure, and a current is halved.

Moreover, to distribute even larger currents, the individual device cells 21 can be connected in parallel to allow the switching of higher currents. This is advantageous, among others, for the fabrication of power semiconductor devices having a relatively high operating voltage, for example in the range of 600 V to 1.2 kV, and or current, for example in the range of 10 to 1000 A per device.

Figure 10 shows a cross-section through a specific power semiconductor device in the form of a MISFET 25. The MISFET 25 comprises a semi-insulating substrate 2 formed, for example, from high purity semi-insulating (HPSI) silicon carbide (SiC), and an insulating layer 3, such as an SiO₂ layer. The substrate 2 may be the actual growth substrate of the MISFET 25, or may be another substrate used to support insulating layer 3 of the MISFET 25. Multiple lateral nanowires and/or nanosheets have been selectively grown in a cavity 4 of the insulating layer 3, for example as detailed above with respect to Figures 2 to 9.

Figure 10 shows that two separate switching structures are formed in a two-part epi-layer 9 selectively grown from two separate passages 5. The two switching structures differ with regard to the configuration of respective pnp structures 28 and 29 implementing the respective switching function. Although not shown, depending on the used materials and desired active structure, a npn structure may also be implemented in the epi-layer 9 (not shown). Attention is drawn to the fact that the specific architecture shown in Figure 10 is used for explanation only and that, in a typical power semiconductor device, both parts of the MISFET 25 may have a similar, or even the same, configuration.

Each of the switching structures comprises a drift region 26 formed from a WBG semiconductor material doped with a charge donor to form an n⁻ region within the epi-layer 9. The drift region 26 may have a length *l* of 5 to 10 µm, and a thickness d of 0.1 to 0.5 µm. In a central part located between the two passages 5, a drain region 27 is formed by creating an n⁺ doped region. In the depicted embodiment, the drain region 27 is overgrown with the WBG material of the respective drift regions 26. Other parts of the drain region 27 are connected to a drain electrode, which is located outside of the cross-section visible in Figure 10.

In the left-hand side of Figure 10, a lateral npn structure 28 is shown. The lateral npn structure 28 comprises, from right to left, a first lateral end of the drift region 26 located in a vertical part of the epi-layer 9, a channel region 30 also arranged in the vertical part of the epi-layer 9, and another n-doped part of the epi-layer 9 forming a source region 31, which starts in the lateral part of the epi-layer 9 and extends further into its second vertical part 13a. A gate electrode 32 is arranged on top of the channel region 30 above the cavity 4 and is used for selectively switching the channel region 30 from a conductive state into a non-conductive state or vice versa.

In the right-hand side of Figure 10, a vertical npn structure 29 is shown, which is arranged in the second vertical part 13b of the epi-layer 9. The vertical npn structure 29 comprises, from bottom to top, a second lateral end of the respective drift layer 26, a positively doped channel region 30 and a source region 31 formed at or near a top surface 3a of the insulation layer 3. The channel region 30 is surrounded by a gate electrode 32. In the depicted embodiment, the second vertical part 13b of the epi-layer 9 as well as the channel region 30 itself form a relatively thin structure, similar to a nanowire. Moreover, the gate electrode 32 surrounds the channel region 30 on all sides, which allows a particularly fast switching response of the vertical npn structure 29.

In the embodiment shown in Figure 10, a passivation layer 33 formed from an insulating material covers the source regions 31 and the overgrown part of the drain region 27. Moreover, since the lateral npn structure 28 and the vertical npn structure 29 use the common drain electrode 26, they can be connected in parallel for higher currents. It is also possible that they form part of a switching bridge between the respective source regions 31 and the common drain region 27, i.e. be connected in series. Although not shown in Figure 10, the drain region 27 may also be located in an upper part of the cavity 4, such that the respective drift regions 26 are connected directly.

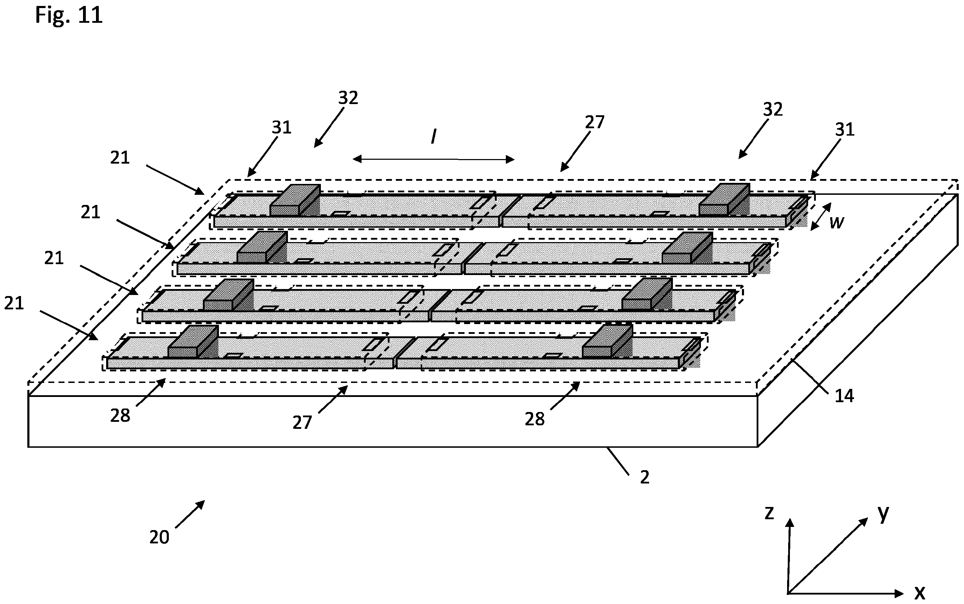

Figure 11 shows another embodiment of a power semiconductor device 20 in the form of a MISFET with multiple cells 21. In the embodiment shown in Figure 11, a total of eight cells 21, each comprising a lateral epi-layer 9, is formed in an array structure. Each of the cells 21 is configured with a lateral npn structure 28 as explained above with regard to the left-hand side of Figure 10. The respective gate electrodes 32 may be switched individually, or may be formed as a common gate bar (not shown). Connections to the central drain regions 27 and the source regions 31at the lateral end of the cells 21 are also not shown.

Figure 11 further shows the dimensions of the power semiconductor device usable in a voltage range of 600 V to 1.2 kV. In particular, the drift region 26 extend over a length *l* from about 1 µm to 30 µm and has a width *w* of about 1 µm. The drift region 26 may have a height of 0.1 to 0.5 µm (not shown). Accordingly, the lateral parts 12 of the epilayers essentially forms nanosheets of WBG material. Instead of nanosheets, fins or nanowires may be also used.

The described lateral WBG epi-layer may be used in different types of power semiconductor devices, such as super-junction MISFETs and/or AccuFETs. Moreover, instead of an npn structure, a single pn or np junction may be implemented in the epi-layer to obtain a power diode. Moreover, such a pn junction may also be replaced with a Schottky junction. In this case, the WBG semiconductor may extend all the way to a metal electrode formed on one or both of its lateral ends.

While the disclosure is amenable to various modifications and alternative forms, specifics thereof have been shown by way of example in the figures and were described above. It should be understood, however, that the intention is not to limit the disclosure to the particular embodiments described. On the contrary, the intention is to cover all modifications, equivalents, and alternatives falling within the scope of the disclosure as defined by the appended set of claims.

### Reference Signs

- 1: semiconductor structure
- 2: substrate
- 2a: surface (of substrate)
- 3: insulation layer
- 3a: surface (of insulation layer)
- 4: cavity
- 5: passage
- 6: pn junction
- 7a, 7b: opening
- 8: Schottky junction
- 9: epi-layer
- 10: seed area
- 11: first vertical part
- 12: lateral part
- 13a, 13b: second vertical part
- 14: first dielectric layer
- 15: hole
- 16: sacrificial layer
- 17: growth template
- 18: second dielectric layer
- 19: electrode
- 20: power semiconductor device
- 21: cell
- 25: MISFET
- 26: drift region
- 27: drain region
- 28: lateral npn structure
- 29: vertical npn structure
- 30: channel region
- 31: source region
- 32: gate electrode
- 33: passivation layer

## Claims

1. A manufacturing method for a power semiconductor device (20), comprising:
- forming at least one insulating layer (3) on a surface (2a) of a crystalline growth substrate (2), the at least one insulating layer (3) comprising at least one cavity (4) extending in a lateral direction within the at least one insulating layer (3);
- selectively growing a wide bandgap, WBG, semiconductor material within the cavity (4) to form a lateral epi-layer (9), wherein a surface area of the growth substrate (2) exposed through at least one passage (5) formed between the at least one cavity (4) and the growth substrate (2) is used as a seed area (10) for epitaxially growing the WBG semiconductor material; and
- forming at least one semiconductor junction, in particular a pn junction (6), a np junction or a Schottky junction (8), within or at an end of the selectively grown WBG semiconductor material.

2. The method of claim 1, wherein the WBG material comprises at least one of 3C, 4H or 6H silicon carbide, SiC.

3. The method of claim 1 or 2, wherein the growth substrate (2) comprises at least one of doped silicon, Si, undoped Si, 4H, 6H or 3C SiC, in particular 3C-on-Si, SiC-on-insulator, SiCOI, semi-insulating SiC, sapphire or gallium nitride.

4. The method of any one of claims 1 to 3, wherein the at least one passage (5) is configured as a defect filter for the WBG material, such that the lateral epi-layer (9) is essentially defect-free.

5. The method of any one of claims 1 to 4, wherein the at least one semiconductor junction is formed by incorporating at least one dopant during the selective growth of the WBG semiconductor material, in particular during the growth of the lateral epi-layer (9).

6. The method of claim 5, wherein a dopant profile used during the selective growth of the WBG semiconductor material comprises at least one step or box with respect to a concentration of the at least one dopant.

7. The method of any one of claims 1 to 6, wherein the step of forming at least one insulating layer (3) comprises:
- forming a first dielectric layer (14), in particular a first silicon dioxide layer, on the surface (2a) of the growth substrate (2);
- forming at least one hole (15) in the first dielectric layer (14) to form the at least one passage (5);
- depositing and structuring a sacrificial material in an area corresponding to the at least one cavity (4);
- forming a second dielectric layer (18), in particular a second silicon dioxide layer, on the first dielectric layer (14) and the sacrificial material; and
- removing the sacrificial material so as to form the at least one cavity (4) between the first dielectric layer (14) and the second dielectric layer (18).

8. The method of any one of claims 1 to 7, wherein
- the power semiconductor device (20) comprises a metal insulator semiconductor field effect transistor, MISFET (25), in particular one of a lateral super-junction MISFET, an IGBT or an AccuFET;
- in the step of selectively growing the WBG semiconductor material, a lateral drift region (26) of the MISFET (25) is grown; and
- the at least one semiconductor junction is formed as part of a lateral npn structure (28), a lateral pnp structure, a vertical npn structure (29), or a vertical npn structure of the MISFET (25).

9. The method of claim 8, further comprising at least one of the following steps:
- forming at least one gate electrode (32), the at least one gate electrode (32) completely or partially surrounding the selectively grown WBG semiconductor material;
- forming a source region (31) at a first lateral end and/or in a central section of the lateral epi-layer (9); and/or
- forming a drain region (27) in the central section and/or at a second lateral end of the lateral epi-layer (9).

10. A power semiconductor device (20), comprising:
- a substrate (2) comprising a first material;
- at least one insulating layer (3) arranged on a surface (2a) of the substrate (2) and comprising at least one cavity (4), the at least one cavity (4) extending in a lateral direction within the at least one insulating layer (3) ;
- at least one passage (5) formed between the at least one cavity (4) and the substrate (2);
- at least one epi-layer (9) comprising a second material, a first part of the at least one epi-layer (9) extending in the lateral direction in the at least one cavity (4), and at least a second part of the at least one epi-layer (9) extending in a vertical direction through the passage (5) to contact the first material, wherein the second material is a wide bandgap, WBG, semiconductor material different from the first material; and
- at least one semiconductor junction, in particular a pn junction (6), a np junction or a Schottky junction (8), formed within or at an end of the at least one epi-layer (9) .

11. The power semiconductor device (20) of claim 10, wherein:
- the first material comprises at least one of doped silicon, Si, undoped Si, 4H, 6H or 3C silicon carbide, in particular 3C-on-Si, SiC-on-insulator, SiCOI, semi-insulating SiC, sapphire or gallium nitride;
- the second material comprises at least one of 3C, 4H or 6H SiC; and/or
- the at least one insulating layer (3) comprises SiO₂, Si₃N₄, Al₂O₃.

12. The power semiconductor device (20) of claim 10 or 11, wherein:
- the first part (12) of the at least one epi-layer (9) extends in the lateral direction for 1 to 30, preferably for 5 to 10 µm;
- the first part (12) of the at least one epi-layer (9) extends in a vertical direction for 0.1 to 0.5 µm;
- the first part (12) of the at least one epi-layer (9) extends in the lateral direction for a first length, the first length exceeding a depth of the cavity (4) in a vertical direction (24) by a factor of 10 or more; and/or
- the power semiconductor device (20) comprises multiple lateral parts of the at least one epi-layer (9) and/or multiple passages (5) formed between the at least one cavity (4) and the substrate (2), wherein a pitch distance of the multiple lateral parts and/or multiple passages (5), respectively, lies in the range of 50 to 5000 nm.

13. The power semiconductor device (20) of any one of claims 10 to 12, comprising:
- a lateral drift region (26), wherein the lateral drift region (26) comprises at least a first section of the first part (12) of the at least one epi-layer (9), the first section comprising a first dopant to form a semiconductor material of a first type, in particular an n type WBG semiconductor material; and/or
- a lateral npn structure (28) and/or vertical npn structure (29), the lateral npn structure (28) and/or vertical npn structure (29) comprising the at least one semiconductor junction formed within the at least one epi-layer (9).

14. The power semiconductor device (20) of claim 13, comprising at least two lateral drift regions (26) and/or lateral npn structures (28), wherein the at least two lateral drift structures (26) and/or lateral npn structures (28) are connected in at least one of a back-to-back or serial fashion.

15. The power semiconductor device (20) of any one of claims 10 to 14, wherein the power semiconductor device (20) comprises a metal insulator semiconductor field effect transistor, MISFET (25), in particular one of a lateral super-junction MISFET, an IGBT or an AccuFET, the MISFET (25) comprising at least one of the following:
- at least one gate electrode (32, 36) partially or completely enclosing the at least one epi-layer (9), in particular a central part of a lateral npn structure (28) or a vertical npn structure (29) formed therein;
- at least one source region (31) arranged at a first lateral end of the epi-layer (9); and
- at least one drain region (27) arranged at a second lateral end or in a central section of the epi-layer (9).
